Europäisches Patentamt

European Patent Office

Office européen des brevets

(11) Numéro de publication: **0 219 394**
A1

## (12) DEMANDE DE BREVET EUROPEEN

(21) Numéro de dépôt: **86402038.3**

(22) Date de dépôt: **17.09.86**

(51) Int. Cl.⁴: **H 05 K 3/42**
**H 05 K 3/10**

(30) Priorité: **18.09.85 FR 8513803**

(43) Date de publication de la demande:
**22.04.87 Bulletin 87/17**

�astcontractants désignés:
**AT BE CH DE GB IT LI LU NL SE**

(71) Demandeur: **Société Anonyme E A T Société d'Etude et d'Assistance Technique**
**20 Rue A. Seyboth**
**F-67000 Strasbourg (FR)**

(72) Inventeur: **Wolfram, Claude, J.C.J.**
**11 Rue Victor Nessler**
**Strasbourg Bas-Rhin (FR)**

(74) Mandataire: **Rataboul, Michel**
**Cabinet Michel Rataboul 69, rue de Richelieu**
**F-75002 Paris (FR)**

(54) **Procédé pour la fabrication de supports de circuits électriques.**

㉝ Le procédé concerne la fabrication de supports de circuits électriques et, en particulier, de circuits imprimés. Il comprend les étapes connues qui consistent à obtenir une plaque support 1, à la recouvrir d'un revêtement conducteur 2-3 sur ses deux faces, à la percer ensuite de trous 4, puis à effectuer un dépôt électrolytique d'un matériau conducteur à des emplacements pré-déterminés, pour lequel le dépôt préalable d'un revêtement conducteur 5 est indispensable.

Après ce dépôt indispensable (5) on provoque une discontinuité électrique autour des trous 4 voulus, par exemple en creusant des sillons 6 et 7, de sorte que le revêtement électrolytique ultérieur ne se dépose pas dans les trous 4 et qu'en outre, lors de la finition de la plaque, le revêtement conducteur 5 disparaît, les trous 4 retrouvant leur diamètre d'origine qui, lui, peut être très précis.

EP 0 219 394 A1

**Description**

PROCEDE POUR LA FABRICATION DE SUPPORTS DE CIRCUITS ELECTRIQUES

On sait que pour obtenir des supports de circuits électriques, notamment de circuits dits "imprimés", on doit exécuter un certain nombre de phases de traitement à partir d'une plaque pour que celle-ci soit finalement munie des circuits conducteurs voulus alors qu'elle-même est obtenue en un matériau isolant.

Cette plaque doit par ailleurs être traversée de nombreux trous dans lesquels doivent être insérées des pattes de connexion de composants électriques et électroniques, de sorte que les parois de ces trous doivent également être recouvertes d'un dépôt conducteur par lequel les deux faces de la plaque sont électriquement reliées.

Malheureusement, ces plaques doivent aussi être percées de trous qui servent à leur positionnement lors de l'insertion automatique des composants électroniques, ces trous de positionnement étant connus dans la practique sous le nom de " trous de locating".

Or, l'insertion automatique est une opération de précision et il en résulte que les trous de positionnement doivent avoir un emplacement très précis at que leur diamètre doit respector des tolérances très sévères c'est-à-dire de l'ordre de 4/100 de millimètres au plus.

Mais les revêtements conducteurs obtenus par éloctrolyse ne permettent pas de ganrantir une telle précision.

Il y a aussi des cas où l'on désire que des trous, autres que ceux de positionnement, gardent le diamètre et l'état de surface qu'ils ont avant le dépôt électrolytique de matériau conducteur.

La présente invention apporte une solution à ces problèmes et permet d'obtenir des supports de circuits électriques ayant des trous, notamment de positionnement, dont le diamètre reste ce que la machine qui les a créés lui a donné de précision.

A cette fin, l'invention a pour objet un procédé pour la fabrication de supports de circuits électriques, du type comprenant les étapes qui consistent à obtenir une plaque, à la recouvrir d'un revêtement conducteur sur ses deux faces, à la percer de trous, puis à effectuer un dépôt électrolytique d'un matériau conducteur à des emplacements pré-déterminés, caractérisé en ce qu'après le perçage des trous et avant le dépôt électrolytique, on provoque une discontinuité de la conductibilité électrique autour d'au moins certains des trous, sur au moins l'une des deux faces de la plaque, afin d'empêcher le dépôt électrolytique sur les parois de ces trous.

Selon une caractéristique de l'invention, la plaque étant recouverte d'un revêtement conducteur sur ses deux faces et sur les parois des trous, on provoque la discontinuité de la conductibilité électrique en retirant ce revêtement selon des zones localisées autout desdits trous.

L'invention sera mieux comprise par la description détaillée ci-après faite en référence au dessin annexé. Bien entendu, la description et le dessin ne sont donnés qu'à titre d'exemple indicatif et non limitatif.

Les figures 1 à 9 sont des vues schématiques décomposant le procédé de fabrication conforme à l'invention depuis une plaque simple (fig. 1) jusqu'à la plaque terminée et munie des différents circuits conducteurs (fig. 9).

La figure 10 est une vue schématique partielle en plan d'une plaque correspondant à la phase de traitement représentée par la figure 5.

Les figures 11 à 13 sont des vues schématiques montrant trois phases permettant de réaliser la discontinuité de la conductibilité au moyen d'une machine outil.

La figure 14 est une vue schématique partielle montrant une plaque conforme à l'invention après réalisation de la discontinuité électrique, c'est-à-dire après intervention de la machine outil évoquée aux figures 11 à 13, cette figure 14 étant identique à la figure 5.

La figure 15 est un vue schématique partielle en plan d'une plaque conforme à l'invention telle qu'elle se présente à la fin du procédé de fabrication, cette figure correspondant à la vue en coupe de la figure 9.

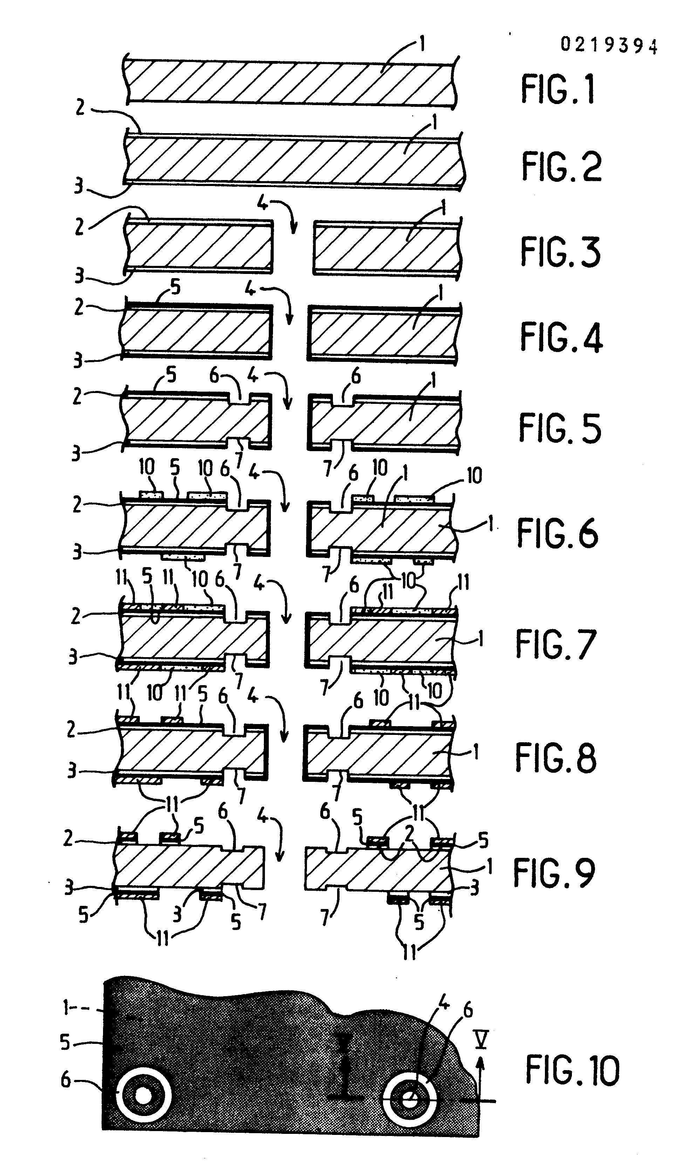

En se reportant aux figures 1 à 10, on voit qu'un procédé conforme à l'invention pour la fabrication de supports de circuits électriques prévoit d'abord l'obtention d'une plaque 1 en un matériau isolant tel qu'une matière synthétique, cette plaque pouvant par example être obtenue par découpage d'une feuille plus grande.

Une telle plaque 1 est ensuite recouverte de revêtements conducteurs 2 et 3 sur ses deux faces afin que celles-ci soient conductrices, dans le but d'obtenir ultérieurement une continuité de la conductibilité électrique entre les deux faces.

Lorsque la plaque 1 est ainsi revêtue, on procède au perçage de tous les trous qui sont nécessaires à un circuit donné ainsi qu'au perçage des trous de positionnement dont on n'a ici représenté qu'un seul désigné par la référence 4.

La plaque 1 est alors soumise au dépôt d'un second revêtement conducteur 5 par des moyens chimiques afin que le revêtement 5 s'étende dans tous les trous, y compris le trou 4, et sur les deux faces de la plaque 1 pour réaliser ainsi une continuité de la conductibilité électrique entre les deux faces de la plaque 1, via les trous.

Grâce à cette continuité, il est possible alors de procéder à des dépôts électrolytiques et le problème de l'invention est de s'opposer à ces dépôts dans certains trous, et notamment dans les trous de positionnement tels que le trou 4, pour que ceux-ci gardent exactement les dimensions qu'il ont lorsque la plaque 1 est dans l'état schématisé sur la figure 3.

Conformément à l'invention, on provoque une discontinuité de cette conductibilité électrique autour des trous dont on veut conserver un diamètre précis et/ou un état électrique neutre et, pour cela, on retire le revêtement 5 selon une zone fermée sur elle-même autour de chaque trou que l'on veut protéger.

Ici, ce retrait est obtenu mécaniquement et l'on crée donc un sillon 6 circulaire par des moyens que l'on décrira plus loin.

Il pourrait suffire de créer le seul sillon 6 sur une face de la plaque 1 mais, dans la practique, il s'avère préférable de créer aussi un sillon 7 symétrique au sillon 6 sur l'autre face de la plaque 1, comme cela est représenté sur les figures 5 à 10, 14 et 15.

Après avoir réalisé cette opération de discontinuité par création des sillons 6 et 7, la plaque 1 se présente comme indiqué par la figure 10 où l'on voit une face de la plaque 1 entièrement recouverte du revêtement 5 et où chaque trou protégé est entouré d'un sillon 6 laissant apparaître la matière constitutive de la plaque 1 qui est isolante.

Grâce à la présence du revêtement conducteur 5, il y a continuité électrique entre les deux faces de la plaque 1 sauf par les trous protégés au moyen de sillons 6 et 7, de sorte que la plaque 1 peut recevoir, selon la technique bien connue de la galvanoplastie, un revêtement provisoire 10 qui ne se dépose que sur des zones déterminées, grâce à un traitement qui a rendu sélectivement ces zones aptes à recevoir le revêtement 10 tandis que les autres zones en sont empêchées et restent libres (figure 6).

La plaque 1 portant le revêtement 10 est ensuite soumise à une opération d'électrolyse pour le dépôt d'un revêtement conducteur 11 qui ne se fixe à la plaque 1 que sur le revêtement 5, c'est-à-dire dans les zones ne comprenant pas le revêtement 10, ainsi que cela est représenté sur la figure 7.

On peut alors procéder par des moyens chimiques au retrait du revêtement 10 afin que seul le revêtement conducteur 11 soit apparent ainsi que cela est représenté sur la figure 8.

Enfin, on retire à la fois le revêtement 5 et les revêtement 2 et 3 au cours d'une opération chimique mais ceux-ci ne disparaissent pas aux endroits qui ont été recouverts par le revêtement 11, comme cela est représenté sur la figure 9.

On constate qu'après formation du trou 4 (fig.3) les parois de celiu-ci sont recouvertes par le revêtement 5 puisque celui-ci est déposé par des voies chimiques qui ne font pas intervenir la continuité de la conductibilité électrique entre les deux faces de la plaques 1, cette continuité n'existant pas à ce stade.

On voit également qu'à la fin du procédé (fig.9), le trou 4 est débarrassé du revêtement 5 et retrouve donc exactement les dimensions qu'on lui a données à l'origine, dimensions qui peuvent être très précises (figure 3).

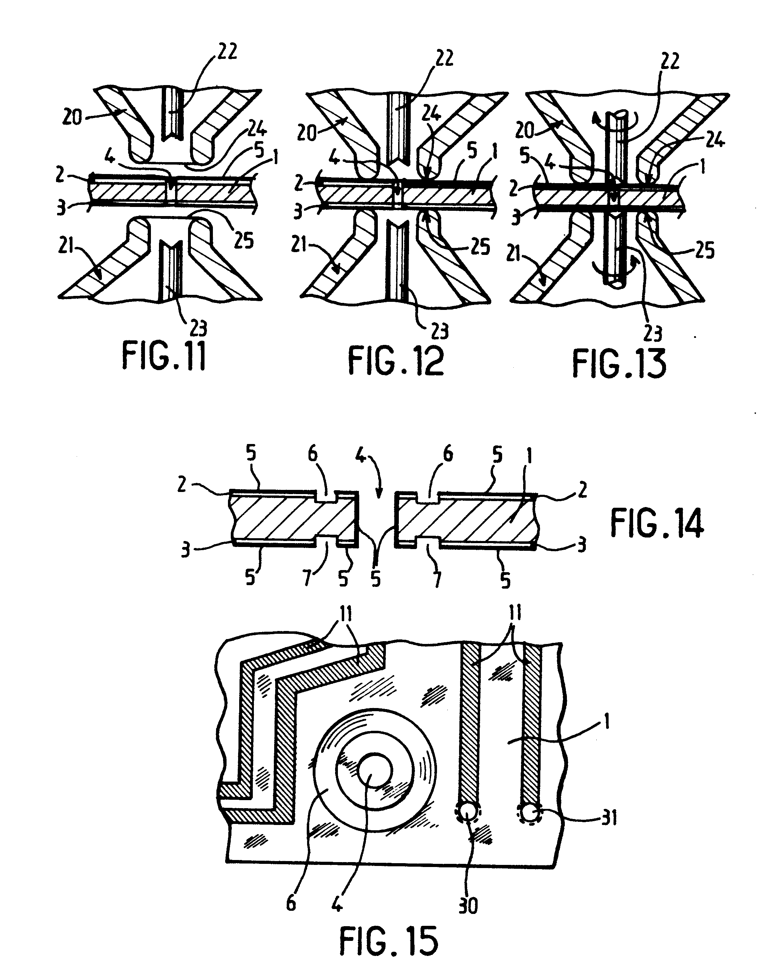

En se reportant aux figures 11 à 13, on voit que pour former simultanément les sillons 6 et 7 on peut utiliser une machine outil comprenant deux têtes 20 et 21 situées face à face et laissant subsister en espace entre elles avec un jeu suffisant pour pouvoir y disposer une plaque 1 recouverte des revêtements 2, 3 et 5. Au centre des têtes 20 et 21, se trouvent deux forêts rotatifs 22 et 23.

La mise en place de la plaque 1 peut être obtenue de manière très précise en utilisant les trous existants de la plaque 1 et lorsque cette position a été obtenue, on commande l'approche des têtes 20 et 21 l'une vers l'autre de telle sorte que leurs bords arrondis respectivement 24 et 25 pincent entre elles la plaque 1 et la maintiennent tout autour du trou central 4 à protéger (fig.12) puis grand cela est obtenu on provoque simultanément l'approche et la rotation des forêts 22 et 23 qui sont du type connu en soi pour n'agir que par leur périphérie (figure 13).

A la fin de cette opération, la plaque 1 se présente comme indiqué par la figure 14, laquelle correspond très exactement à la figure 5.

Sur la figure 15 on a représenté d'une manière schématique et vue en plan une partie d'une plaque 1 telle qu'elle se présente lorsqu'elle est tout à fait terminée c'est-à-dire lorsque qu'elle correspond au schéma de la figure 9.

On voit que la plaque 1 est apparente, dans son état d'origine telle qu'elle est représentée sur la figure 1, et qu'elle porte le revêtement 11 conducteur sous forme d'un circuit plus ou moins complexe.

Comme on a retiré aussi bien le revêtement 5 que les revêtements 2 et 3, il n'y a pas de différence d'aspect entre la plaque 1 proprement dite, le sillon 6 et la partie située entre le sillon 6 et le trou 4.

En revanche, lorsque la plaque 1 n'a pas encore reçu les composants électroniques, elle présente des trous recouverts intérieurement par le revêtement 5 et par le revêtement 11 afin d'assurer la continuité électrique entre les conducteurs 11 d'une face et des conducteurs éventuels de l'autre face.

Sur la figure 15, les trous 30 et 31 ont donc un diamètre plus petit que celui qu'ils avaient lorsqu'ils ont été créés dans la plaque 1 puisque leur parois sont recouvertes de matériau conducteur, ce que l'on a évoqué par un trait pointillé qui représente le diamètre d'origine tandis que le trait continu central représente le diamètre du trou revêtu.

Le procédé conforme à l'invention peut être utilisé tout particulièrement pour protéger les trous de positionnement mais bien entendu il peut aussi être utilisé pour certains trous autres que ceux destinés au positionnement c'est-à-dire chaque fois que l'on veut éviter la continuité électrique par ces trous.

**Revendications**

1- Procédé pour la fabrication de supports de circuits électriques, du type comprenant les étapes qui consistent à obtenir une plaque (1), à la recouvrir d'un revêtement conducteur (2-3) sur ces deux faces, à la percer de trous (4), puis à effecteur un dépôt électrolytique d'un matériau conducteur (11) à des emplacements pré-déterminés, caractérisé en ce qu'après le perçage des trous (4) et avant le dépôt électrolytique (11), on provoque une discontinuité de la conductibilité électrique autour d'au moins certains des trous (4), sur au moins l'une des deux faces de la plaque (1), afin d'empêcher le dépôt électrolytique sur les parois de ces trous (4).

2- Procédé selon la revendication 1, caractérisé en ce que la plaque (1) étant recouverte d'un revêtement conducteur (5) sur ses deux faces et sur les parois des trous (4), on provoque la discontinuité de la conductibilité électrique en retirant ce revêtement (5) selon des zones (6-7) localisées autour desdits trous (4).

0219394

FIG.1

FIG.2

FIG.3

FIG.4

FIG.5

FIG.6

FIG.7

FIG.8

FIG.9

FIG.10

0219394

FIG.11  FIG.12  FIG.13

FIG.14

FIG.15

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | GB-A-1 101 299  (FRIDEN INC.) * Page 2, ligne 16 - page 3, ligne 39; figures 1-4 * | 1 | H 05 K   3/42 H 05 K   3/10 |
| | --- | | |
| A | US-A-4 486 273  (GENERAL MOTORS CORP.) *  Colonne 2, ligne 41 - colonne 4, ligne 9 * | 1,2 | |
| | --- | | |
| A | CA-A-1 054 259  (CANADIAN GENERAL ELECTRIC CO. LTD.) * Figures 3,4 * | 1 | |
| | --- | | |
| A | FR-A-2 471 725  (SA PHILIPS INDUSTRIELLE ET COMMERCIALE) | | |
| | ----- | | |

DOMAINES TECHNIQUES
RECHERCHES (Int. Cl.4)

H 05 K
C 25 D

Le présent rapport de recherche a été établi pour toutes les revendications

| Lieu de la recherche | Date d'achèvement de la recherche | Examinateur |
|---|---|---|
| LA HAYE | 03-12-1986 | SCHUERMANS N.F.G. |